# EUROPEAN PATENT APPLICATION

(11) **EP 2 592 363 A1**
(43) Date of publication of application: **15.05.2013**
(21) Application number: 11189021.6
(22) Date of filing: 14.11.2011
(51) Int. Cl.: F24J 2/05, F24J 2/32, F25B 21/04, F25B 27/00, F28D 15/02, H01L 23/38, H01L 35/28

(54) **Energy conversion device**

(71) Applicant: Entry Technology Holding B.V., 3911 CA Rhenen (NL)
(72) Inventor: van Berkel, Jacob, 3911 CA Rheden (NL)
(74) Representative: van Essen, Peter Augustinus

(57) **Abstract**

The invention provides an energy conversion device comprising at least one vacuum tube heat pipe having a vacuum tube heat pipe condenser end and a vacuum tube heat pipe evaporator end at least one ambient heat pipe having an ambient heat pipe heat exchanger condenser end and an ambient heat pipe heat exchanger evaporator end at least one thermoelectric conversion element having a first end and a second end which first end and second end have a temperature difference with respect to one another when said thermoelectric conversion element is in operation, wherein said vacuum tube heat pipe condenser end and said ambient heat pipe condenser end are thermally coupled to said first end of said thermoelectric conversion element, and wherein said at least one vacuum tube heat pipe collector and said at least one ambient heat pipe heat exchanger are configured functionally parallel.

## Description

### Field of the invention

The invention relates to an energy conversion device.

### Background of the invention

Energy consumption in commercial and residential buildings worldwide accounts for about one-third of the world's energy and one-quarter of greenhouse gas emissions. If current trends continue, by 2025 buildings worldwide will be the largest consumers of global energy

The most straightforward source of sustainable energy in the built environment is Solar Energy. Roughly in 1 hour the sun delivers as much energy to the earth's surface as is needed by humanity in 1 year.

Usage of solar energy for heating, cooling and electricity is a challenge due to the in-synchrony of supply (especially in summertime) and demand (especially wintertime). For heat, a traditional approach is to capture solar energy in summertime, store it and use it in wintertime. The bottleneck in this approach is the efficiency of the storage system. Especially for small systems (single houses) the storage efficiency is relatively low and the space requirement (volume) high. R&D is focussed on efficient thermal storage techniques and storage media (other than storage as sensible heat in water). Examples are thermal energy storage in Phase Change Materials and thermochemical or thermo-physical reactions of compounds. One example is thermal energy storage in sorption processes, e.g. water vapour in Silica Gel or Zeolite. Though thermal energy storage density indeed may be higher than the energy storage density of water, the volume required to achieve seasonal storage for dwellings still is in the order of several cubic meters, which in many dwellings is not available. In addition, the costs associated with the technique (vacuum systems) and storage media (PCM's, sorbents) are high.

### Summary of the invention

The invention aims to substantially reduce the carbon dioxide emission for space heating, tap water heating en (optionally) space cooling of buildings, in particular residential buildings.

To that end, the invention provides an energy conversion device comprising:
- at least one vacuum tube heat pipe having a vacuum tube heat pipe condenser end and a vacuum tube heat pipe evaporator end;
- at least one ambient heat pipe having an ambient heat pipe condenser end and an ambient heat pipe evaporator end;
- at least one thermoelectric conversion element having a first end and a second end which first end and second end have a temperature difference with respect to one another when said thermoelectric conversion element is in operation,
wherein said vacuum tube heat pipe condenser end and said ambient heat pipe condenser end are thermally coupled to said first end of said thermoelectric conversion element, and wherein said at least one vacuum tube heat pipe and said at least one ambient heat pipe are configured functionally parallel.

In the invention outlined in this application, aims at a strategy in which an embodiment, it provides a roof-mounted energy conversions device that:
1. Generates electricity and thermal energy (heat) by using solar radiation: "solar co-generation mode".
2. Generates thermal energy by using ambient heat and electricity: "heat pump mode".
3. Optionally can generate thermal energy (cold) by using ambient heat and electricity: "refrigerator mode".

The invention thus enables to reduce the use of "external" energy of a building. External here refers to: gas, oil, wood or electricity imported from outside the building's direct environment.

An advantage of using these system components in the device is the absence of moving components, for instance rotary or oscillating equipment, and as a result no vibration, noise, or wear occurs.

In summertime the device operates mostly as a cogeneration device, producing both thermal energy for tap water heating as well as electricity. The device is dimensioned such that more electricity is generated than directly needed in the building, the surplus is fed into the mains electricity grid. In this way, it replaces or "saves" fossil fuel or nuclear energy generated electricity.

In wintertime, or cold nights, the device operated as heat pump, using electricity from the mains grid. In this mode of operation, it withdraws fossil fuel or nuclear energy generated electricity, saved during the summer, and uses it to pump up thermal energy extracted from the ambient to the desired indoor temperature level.

Optionally, the device can be used in "refrigeration" mode, using electricity from the mains grid to extract thermal energy from the indoor space, in other words, to cool the indoor space, and pump this heat away to the ambient.

The device can in an embodiment be composed of the main components:
1. Peltier of Seebeck element, serving both in electricity production mode (producing electricity from temperature differences) and in heat pump/refrigerator mode, using electricity to create temperature differences.
2. Vacuum tube solar collectors using a solar energy absorber with heat pipe for thermal energy transport.
3. Ambient energy heat exchanger with heat pipe for thermal energy transport.

In general, the use of vacuum tube heat pipe elements is well known in the field of solar energy collectors. For instance, in US 4.059.093 an early example of such a vacuum tube heat pipe is described. Many improvements were made to that first concept, leading to improved and optimized vacuum heat pipe elements. These elements may also be referred to in literature as "evacuated-tube solar heat collector", "vacuum heat pipe" and many other names. A heat pipe is a device that efficiently transports heat from one end to the heat pipe to the other end of the heat pipe through evaporation and condensation of a fluid inside the heat pipe. The heat pipe thus has an evaporator end and a condenser end. Often, a fluid in its liquid phase is in rest at the gravitationally lower end of the heat pipe, the evaporator end. When heated, the liquid evaporates and starts to travel to the gravitationally upper end, where it condensates at the condenser end of the heat pipe. Thus, the fluid changes phase from gas to liquid again. The liquid flows back to the evaporator end under the influence of gravity.

In the vacuum heat pipe, the actual heat pipe is enclosed by a transparent, usually glass, dewar. At or near its condenser end, the dewar closes against the surface of the heat pipe, leaving the condenser end extending from the dewar. The dewar can be attached to the, usually metal, surface of the heat pipe, or a stop closes the space between the dewar and the heat pipe surface. Alternatively, the actual heat pipe is enclosed by a glass envelope that is fixed to the surface of the heat pipe in order to provide a evacuated space between the envelope and the heat pipe. The vacuum within the evacuated tubes reduce conducted heat losses. In generalized wordings, the heat pipe has an envelope that allows light to pass and reach a radiation-absorbing surface of the heat pipe. In an embodiment, the outer tubes are covered with a semi transparent coating. This coating allows light to pass from the outside and reflects light coming from inside. In an evacuated tube collector, sunlight passing through an outer glass tube heats the absorber tube contained within it. The absorber can either consist of copper (glass-metal) or specially-coated glass tubing (glass-glass). The glass-metal evacuated tubes are typically sealed at the manifold end, and the absorber is actually sealed in the vacuum, thus the fact that the absorber and heat pipe are dissimilar metals creates no corrosion problems. The better quality systems use foam insulation in the manifold. low iron glass is used in the higher quality evacuated tubes manufacture. The skilled person knows these and similar elements regarding heat pipes and in particular vacuum heat pipe.

There exist, however, also heat pipes that can operate in an opposite way against the forces of gravity. In these heat pipes, the fluid in its liquid phase at the condenser end is made to creep up against the inner surface of the heat pipe, against the force of gravity, by other means. Some of these heat pipes use a wick at the inner surface of the heat pipe. Some examples of such a heat pipe are described in US4027653, US4067315 and US4474170. In particular, it was found that a heat pipe including a wick at its inner surface has some advantages in the current invention that is going to be explained below.

Furthermore, embodiments of heat pipes are known that comprise a valve inside the heat pipe and that separates the evaporator end from the condenser end. Thus, it prevents the temperature and thus the pressure of the fluid inside the heat pipe from becoming too high. In fact, it operationally switches off the heat pipe. Often, these heat pipes use a spring-biased valve that opens in the internal pressure inside the heat pipe becomes too high. An example of such a heat pipe is disclosed in US2010116265A1. These types of heat pipes can also be used in the current invention, not only for the evacuated heat pipes, but also for the ambient heat pipe and the further heat pipe. In particular, a heat pipe with a controllable valve can be used. In such a heat pipe, the temperature of the heat pipe is measured and input in a controller. The controller in turn operates the valve depending on the mode of operation of the energy conversion device as explained further below.

In the current invention, a thermoelectric conversion element is used. Such an element requires no moving hardware. The thermoelectric conversion element has a hot end and a cold end. In operation when electrical power is applied to the thermoelectric converter element, the converter element has an end that absorbs heat and which usually will be cold, and an end that will emit heat and that will be cold. These ends are here referred to as the cold end and the hot end.

In an embodiment, the thermoelectric conversion element comprises one selected form the group of solid state thermo-electric devices and thermionic devices. In an embodiment, a solid state thermo-electric device is selected from a Peltier device, a Seebeck device, a JTEC device, an AMTEC device.

The Themoelectric elements that can be used in the current invention can be any suitable device or element that converts heat energy into electrical energy, such as a thermocouple or Peltier element. Such thermoelectric elements generate aa voltage based on a thermal gradient across the element between the first and second end thereof. Thermoelectric elements that are suited for the current invention, can be used in so-called thermoelectric "generation" mode. In this generation mode heat is received by one side of the element, viz. the first active surface, and rejected or disposed of at the second active or cold surface of the element, the first and second active surfaces usually being opposite sides of the element. The heat flow through the element goes together with a temperature difference between the first active surface and the second active surface, the temperature of the first active surface being higher than the temperature of the second active surface. In the generation mode an electrical current is produced, which is dependent on the temperature difference between the first active and second active surface. In this generation mode, a temperature gradient is maintained across the element and the heat flux which passes through the module is converted into electrical power. This is known as Seebeck effect. In the generation mode electrical energy is generated by the element and the generated electrical energy can be used to feed other components of the system such as for example a fan, a battery, a lighting arrangement or a combination thereof. Thermoelectric elements can also be used in so-called thermoelectric "cooling" mode. In this cooling mode an electric current is applied to a thermoelectric element. In cooling mode, heat is pumped from one side or junction (the cold side or cold junction) to another side or junction (the hot side or hot junction). The cold junction will drop below ambient temperature provided heat is removed from the hot side. The temperature gradient will vary according to the magnitude of current applied. In cooling mode, an electrical current is supplied to the element which results to one side of the element becoming cold. This is known as Peltier effect. In the cooling mode electrical energy is consumed by the element. By actively feeding an electrical current into the thermoelectric element by the current source the Peltier effect can be used as an emergency measure in case the first active surface, i.e. the surface which reaches the highest temperature, gets overheated. By the provision of a current source it is possible to operate the thermoelectric element in a forced cooling mode of itself.

Currently, there are many developments in the area of solid state thermoelectric converters that may be used in the current invention. An example is for instance disclosed in US2011114145A1. It provides for a nanostructure, or an array of such nanostructures, each comprising a rough surface, and a doped or undoped semiconductor. The nanostructure is an one-dimensional (1-D) nanostructure, such a nanowire, or a two-dimensional (2-D) nanostructure. The nanostructure can be placed between two electrodes and used for thermoelectric power generation or thermoelectric cooling. This document is incorporated herein as if fully set forth.

There hardly is an upper limit to the size of the energy conversion device of the current invention, nor a lower limit. In fact, the energy conversion device can operate with only one evacuated heat pipe setting.. In an embodiment, the energy conversion device in domestic applications may cover a surface area of up to 100 m². To that end, it can have up to about 1000 vacuum heat pipes.

In an embodiment, the energy conversion device comprises at least one further ambient heat pipe having a further heat pipe condenser end and a further heat pipe evaporator end, which evaporator end is thermally coupled to said first end of said thermoelectric conversion element, and said at least one further ambient heat pipe extending functionally in a plane with said vacuum tube heat pipe and said ambient heat pipe. In this configuration, the energy conversion device allows production of electrical power, of heated fluid and of cooled fluid.

In an embodiment, said second end of said thermoelectric conversion element is thermally coupled to a heat exchanger having a fluid passage for exchanging heat with a fluid. Thus, the device can be coupled for instance to a domestic heating or cooling system, and/or can provide heated tap water.

In an embodiment, said thermoelectric conversion element comprises one or more elements selected from the group consisting of a solid state thermoelectric conversion device, an alkali metal thermoelectric converter (AMTEC) device, a thermionic device, a Johnson thermo-electrochemical converter (JTEC) device, and a combination thereof.

In an embodiment, said thermoelectric conversion element comprises a solid state thermoelectric device. In this way, the energy conversion device requires no or a minimal number of mechanically moving parts.

In an embodiment, said thermoelectric conversion element comprises a Peltier device. Such a Peltier device is proven technology and has no moving parts.

In an embodiment, the further heat pipe has an inner surface, and said heat pipe comprises a wick at its inner surface allowing it to operate at an orientation with respect to the force of gravity at which the evaporator end is at a higher potential energy. This allows an even compacter building of the energy conversion device.

In an embodiment, at least one of said vacuum heat pipe, ambient heat pipe, and further ambient heat pipe said comprises a valve, in particular a controllable valve. Using this valve, the energy conversion device can switch between operational modes of electrical power production, hot fluid production and cold fluid production in an easy manner.

In an embodiment, the energy conversion device may be functionally coupled to or be part of a (domestic) heating/cooling system and/or tap water heating system. In such a constellation, this complete device can be set up according to the principle of thermally layered operation, which as such is known to a skilled person. In an embodiment, this may implicate a "low flow" collector flow of below 15 1/m²/h, in particular around 10 1/m²/h. In a further embodiment, the device will have a "back drain" mode. In this mode, fluid from the collector conduits will flow back into a collection vessel in order to protect the device against frost and overheating as soon as a circulation pump stops.

In an embodiment, the energy conversion device further comprises a controller. The energy conversion device can further comprise a temperature sensor operationally coupled to said controller and for determining a temperature of said fluid. In an embodiment, the energy conversion device further comprises a fluid displacement device operationally coupled to said controller and for displacing said fluid through said heat exchanger, and a power sensor operationally coupled to said at least one thermoelectric element and to said controller for determining a electrical power to or from said thermoelectric device. Said controller in an embodiment is adapted for switching between:
- a cogeneration mode in which the power sensor indicates an electrical power resulting from the at least one thermoelectric conversion element of above a set value, and said controller actuates said fluid displacement device to circulate the fluid through said heat exchanger, and
- a heat pump mode in which the power sensor indicates an electrical power below a set value and said controller receives a heating demand, and said controller provides power to said thermoelectric conversion element resulting in a heating of said first end relative to said second end.

In an embodiment, the controller is further adapted for further switching the energy conversion device to:
- a cooling mode in which said controller receives a cooling demand, and said controller provides power to said thermoelectric conversion element in such a way that it commences cooling said first end relative to said second end.

In an embodiment, the invention further relates to a method for converting energy using the energy conversion device. In an embodiment of this method, the energy conversion device further comprises a controller, a temperature sensor operationally coupled to said controller and for determining a temperature of said fluid, a fluid displacement device operationally coupled to said controller and for displacing said fluid through said heat exchanger, and a power sensor for determining a power to or from said thermoelectric device. In an embodiment said method comprises the steps in which said controller:
- switches said energy conversion device to a cogeneration mode when the power sensor indicates an electrical power resulting from the at least one thermoelectric conversion element of above a set value, and said controller actuates said fluid displacement device to circulate the fluid through said heat exchanger, or
- switches said energy conversion device to a heat pump mode when the power sensor indicates an electrical power resulting from the at least one thermoelectric conversion element of below a set value and said controller receives a heating demand, and said controller provides power to said thermoelectric conversion element resulting in a heating of said first end relative to said second end.

The invention further relates to a method for converting energy using the energy conversion device and further comprising a controller, a temperature sensor operationally coupled to said controller and for determining a temperature of said fluid, a fluid displacement device operationally coupled to said controller and for displacing said fluid through said heat exchanger, and a power sensor for determining a power to or from said thermoelectric device. In an embodiment the method comprises the step in which said controller:
- switches said energy device into a cooling mode when said controller receives a cooling demand, and said controller provides power to said thermoelectric conversion element in such a way that it commences cooling said first end relative to said second end.

Elements of the energy conversion device are said to be functionally parallel. This in a broad sense means that the elements are mutually positioned in such a way that in operation they operate as if completely and absolutely, mathematically, parallel. In practice, however, the mutual positioning may deviate a little from being absolutely parallel. In practice, they may deviate up to 10%. Often, the deviation is below 5%. In most cases, the deviation will be less than 1%. The same hold for the feature "functionally in a plane".

In the current text, elements of the energy conversion device are defined to be thermally coupled. In its broadest sense, this means that the elements are mutually arranged to allow heat exchange between various elements as defined. The elements may be in contact with one another via a medium, being a liquid or a gas. Often, thermally coupled means that the elements are in contact with one another. They can be in direct contact. Alternatively, a heat conducting element can be placed between the elements and contacting the elements. In some cases, parts of the elements can be fixed to one another.

The terms "upstream" and "downstream" relate to an arrangement of items or features relative to the propagation of the light from a light generating means or the flow of a fluid. In a first position within a beam of light from the light generating means, a second position in the beam of light closer to the light generating means is "upstream", and a third position within the beam of light further away from the light generating means is "downstream". The same hold for a fluid flow.

The term "substantially" herein, such as in "substantially consists", will be understood by the person skilled in the art. The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices or apparatus herein are amongst others described during operation. As will be clear to the person skilled in the art, the invention is not limited to methods of operation or devices in operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device or apparatus claims enumerating several means, several of these means may be embodied by one and the same item of hardware. The mere fact that certain measures are recited in mutually different dependent claims does not indicate that a combination of these measures cannot be used to advantage.

The invention further applies to an apparatus or device comprising one or more of the characterising features described in the description and/or shown in the attached drawings. The invention further pertains to a method or process comprising one or more of the characterising features described in the description and/or shown in the attached drawings.

The various aspects discussed in this patent can be combined in order to provide additional advantages. Furthermore, some of the features can form the basis for one or more divisional applications.

### Brief description of the drawings

Embodiments of the invention will now be described, by way of example only, with reference to the accompanying schematic drawings in which corresponding reference symbols indicate corresponding parts, and in which:
Figure 1 illustrates schematically in top view an embodiment of an energy conversion device, for production of electricity and heat from solar energy in so-called co-generation mode, and for delivery of heat in so-called heat pump mode;
Figure 2 shows the embodiment of figure 1 in side view;
Figure 3 illustrates schematically in top view another embodiment of an energy conversion device with expansion configuration, for additional absorption of heat, i.e. for cooling;
Figure 4 shows the embodiment of figure 3 in side view;
Figure 5 shows an embodiment similar to that of figure 3 and 4, but with an alternative type of heat pipe;
Figure 6 shows the embodiment of figure 5 in side view;
Figure 7 shows an energy conversion device with a schedule showing an embodiment of an installation for hot and cold water, and
Figure 8 shows an energy conversion device with a schedule showing an embodiment of an installation for combined hot water and heating water or "combi".

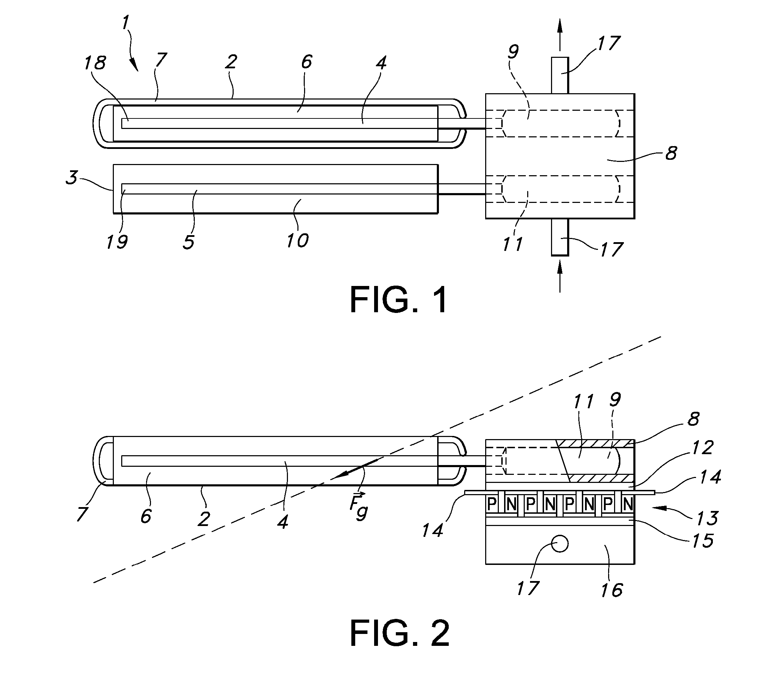

The embodiments of figures 1, 2, figures 3, 4 and figures 5,6 depict one module of the device. In practice the device comprises several modules. Furthermore, the drawings are not necessarily on scale.

### Description of preferred embodiments

Figure 1 schematically depicts an embodiment of a device for energy conversion 1, in this embodiment without an optional cooling facility. The device for energy conversion 1 comprises here two heat pipes 4 and 5, resulting in a vacuum tube heat pipe 2 and an ambient heat pipe 3. Both heat pipes 4 and 5 are thermally coupled with their condenser ends 9, 11, to a first heat exchanger unit 8.

In order to result in a vacuum tube heat pipe 2, heat pipe 4 is enclosed by, or can be provided with, one or more fins 6 to provide an extended heat absorbing surface. Furthermore, it is enclosed by a vacuum tube (Dewar-type) transparent insulation tube 7, thus resulting in the vacuum tube heat pipe 2. In the schematic drawings 1-5 the vacuum tube 7 is indicated with a single line indicating a double walled Dewar which is evacuated inside. The two layer are of a transparent material, for instance glass. The vacuum tube heat pipe 2 has a condensing section or condenser end 9, that is in this embodiment housed in the first heat exchanger unit 8 to establish its thermal contact. The vacuum heat pipe 2 further has an evaporator end 18. In general, a vacuum tube heat pipe as such was already in its general concept described in US 4,059,093, referred to above, and has been further improved afterwards. In the current invention, a vacuum heat pipe optimized for solar heat or solar radiation harvesting is preferred.

The ambient heat pipe 3 is in this embodiment also provided with surface-extending fins 10. The ambient heat pipe 3 has a condenser end 11 and an evaporator end 19. The condenser end 11 is in thermal contact with heat exchanger unit 8.

The first heat exchanger unit 8 in turn is in thermal contact with one side or one end 12 of a Peltier element 13. In this embodiment the Peltier element 13 is even connected to that end 12 via heat exchanger 8. The Peltier element 13 is in this embodiment schematically indicated with electrically interconnected blocks of P-type and N-type semiconductor material and leads 14. Alternatively, a Peltier element can be formed from metal contact surfaces. The Peltier element 13 is in this embodiment housed between two ceramic plates 12 and 15. The side 15 opposite to end 12 of the Peltier element 13 is thermally coupled, in this embodiment even connected to, a second heat exchanger unit 16. This second heat exchanger unit 16 is thermally coupled to a fluid conduit 17. For instance, fluid conduit 17 can be a tube through which water can flow to the space heating and tap water heating system inside a building. In the drawing, the second heat exchanger is depicted in a schematic way. Any type of heat exchanger that can be thermally coupled to one side or end of the Peltier element 13 and that allows a fluid to exchange heat with that end of the Peltier element 13 can be used.

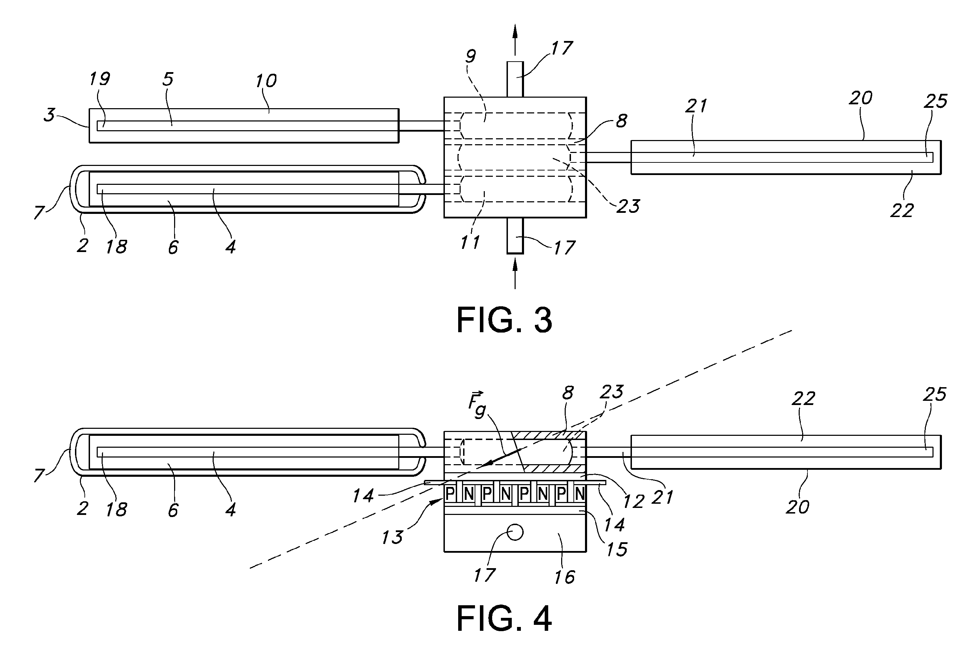

In figures 2 and 4, the direction and working line of the force of gravity Fg is shown. In operation, the energy conversion device is positioned with the longitudinal axes of the heat pipes at an angle with respect to the working line of the force of gravity and the evaporator ends and the condenser ends in a working position. Usually, this will be with the condenser end at a higher potential energy level than the evaporator end. In other words, the condenser ends 9, 11 are higher than the evaporator ends 18, 19. Below, it will be explained that there exist types of heat pipes that operate in an opposite way.

In fact, the energy conversion device of figures 1 and two has two modes of operation, that are referred to as "cogeneration" and "heat pump". In the cogeneration mode, the energy conversion device absorbs (solar) heat and provides heated fluid and electrical power as output. In this mode of operation, the vacuum tube heat pipe is used.

In the second mode of operation, the "heat pump" mode, the Peltier element(s) 13 is/are activated in such a way that its end that is coupled to the first heat exchanger unit 8 decreases in temperature and the end coupled to the second heat exchanger 16 increases in temperature.

In cogeneration mode, the vacuum tube heat pipe 2 is irradiated by the sun and as a result heat is transferred to its condenser end 9. In that way, heat is provided to the first heat exchanger unit 8 and the Peltier element end 12. The opposite, (relatively) cold end 15 of the Peltier element 13 is in an embodiment cooled by water running through the heat transfer tube 17. The temperature of the water flow typically is sufficient to provide space heating en/or tap water heating. Ideally a temperature of 40° C is sufficient for both space heating and tap water heating.

Due to the temperature difference between heat exchanger units 8 and 16, the Peltier element 13 generates electricity that can either be used directly in a dwelling, or fed into the mains grid via leads 14. Water that is heated by the second heat exchanger unit 16 can be stored in an indoor water hot water tank, for later usage, for instance for space heating or tap water heating.

To operate as a heat pump, the ambient heat pipe 3 is thermally coupled to the first heat exchanger unit 8. This ambient heat pipe 3 is not enclosed by a Dewar-flask type transparent insulation tube as is the case with the vacuum tube heat pipe 2. It exchanges heat with the ambient, i.e. absorbs radiation. In heat pump mode, the Peltier element 13 is electrically energized and as a result thermal energy is "pumped" from the first heat exchanger unit 8, which thus decreases in temperature, to the second heat exchanger unit 16, which thus increases in temperature. The decreasing temperature of the first block starts a evaporation/condensation cycle in the ambient heat pipe 3, and thus exchanges heat with the ambient. Water that is heated by the second heat exchanger unit 16 can for instance be in an indoor hot water tank, for later usage for heating or for tap water heating.

Note that this ambient heat pipe 3 does not operate when the device is in the above-described solar cogeneration mode: In that mode, the first heat exchanger unit 8 is at an elevated temperature, usually much higher than ambient temperatures, and as a result no evaporation/condensation cycle is possible in the ambient heat pipe. In fact, when provided with a valve, it is possible to switch the heat pipe off.

In figures 3 and 4 a further embodiment of the energy conversion device 1 is shown. In this embodiment, the energy conversion device of figure 1 is additionally provided with a further ambient heat pipe 20 to facilitate cooling. Thus, the energy conversion device has a third mode of operation, which is referred to as "cooling". The further ambient heat pipe 20 has a heat pipe 21 provided with fins 22 for increasing its emitting surface. The further ambient heat pipe 20 also has a condenser end 23 and an evaporator end 25 at the other end of the heat pipe 21. This heat pipe is thermally coupled with its condenser end to the heat exchange unit 8 and with its evaporator end 25 away from the heat exchange unit 8.

Again the Peltier element 13 is electrically energized via leads 14, but now in an opposite voltage compared to the "heat pump" mode outlined above. As a result, the first heat exchanger unit 8 is now heated and the second heat exchanger unit 16 is cooled to a temperature sufficient for indoor cooling, for instance between 10°C and 15°C. The first heat exchanger unit 8, that is heated to typically temperature slightly above ambient temperature of usually between 25°C and 30°C, now transfers thermal energy to the evaporation end 25 of the further ambient heat pipe 20 that now effectively transfers heat to the ambient air. In an embodiment, this heat transfer process takes place at night-time with moderate ambient temperatures and without heat input resulting from solar radiation onto the vacuum tube heat pipe 2. In the embodiment in which conduit 17 is a tube for water, the water that is cooled by the second heat exchanger unit 16 can again be stored in an indoor cold water tank for daytime usage, for instance for space cooling.

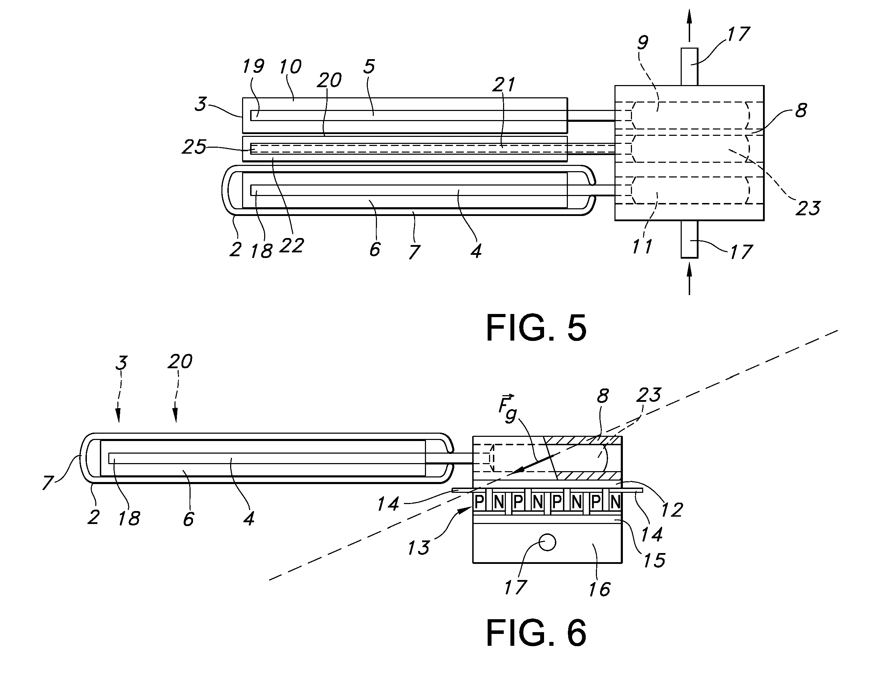

In figures 5 and 6, an embodiment of the device for energy conversion 1 is shown. In this embodiment, the further ambient heat pipe 20 used a provision inside the heat pipe 21 and that allows the fluid inside the heat pipe 21 to flow from the condenser end 23 to the evaporator end 25 against the force of gravity. Often, such a heat pipe has a wick of some sort inside the heat pipe 20. Using such a heat pipe, all the heat pipes can be provided in a single row. Figure 5 illustrates this. Figure 6 again shows this embodiment in side view. The heat pipes are again in one plane.

In an embodiment, in order to avoid undesired heat transfer in solar energy cogeneration, for instance when the first heat exchanger block is heated to temperatures of above 50°C, in particular above 100°C, the further ambient heat pipe 20 is temperature limited in the following way. By virtue of a gas expansion valve (not shown), the evaporator section of the further heat pipe 20 is separated from the condenser section, for instance for temperatures above 30°C, in particular above 40°C. As a result, the further ambient heat pipe is prevented from operating at elevated temperatures and does not exchange heat with the vacuum tube heat pipe 2. The same can be do for the other heat pipes in the other modes of operation.

In both embodiments of figures 1, 2 and figures 3, 4, the energy conversion device 1 is provided with one vacuum tube heat pipe 2, one ambient heat pipe 3, and one further ambient heat pipe 20. Usually, however, the energy conversion device will have several vacuum tube heat pipes 2, several ambient heat pipes 3 and several further ambient heat pipes 20. For instance, the energy conversion device 1 shown in the drawings can be simply multiplexed, placing several of these devices next to one another. For instance, the unit of figures 1-5 can be multiplexed a number of times with each time a vacuum tube heat pipe 2, a further ambient heat pipe 20, and an ambient heat pipe 3. Alternatively, other permutations of these three heat pipes 2, 3, 20 are possible. Furthermore, the number or capacity of these heat pipes does not need to be equal.

The energy conversion device 1 does not require active, mechanically operated control equipment, like for instance actuators, valves etc. The parameters that are controlled in the part of the energy conversion device 1 that may be roof mounted are a fluid flow, often a water flow, through the conduit 17 and the electrical mode of operation of the thermoelectrical device or devices.

In an embodiment, inside a building envelope, for instance a house (residential building), an office building, a factory, conduit 17 can be coupled to a (central) heating and (optionally) cooling system (radiators, convectors, under floor heating and/of cooling equipment), pumps, distribution manifolds and also to storage facilities for buffering of hot and /or cold water. The hot water can serves both space heating and tap water heating.

The above description gives the system in 3 modes: 1) "cogeneration" (generation of Electricity using a thermal energy flow from ambient into building interior); 2) heat pump (using Electricity to pump thermal energy from a low temperature ambient into the building; and 3) cooling (using Electricity to pump thermal energy from the building interior to high temperature ambient). It is acknowledged that there actually is a 4th mode of operation, that can also be indicated as "cogeneration". In this mode, generation of electricity takes place using a thermal energy flow from a high temperature building interior to ambient. This 4th mode could be relevant for buildings with undesired internal temperatures that are higher than ambient temperature. This mode however is not described in further detail.

The fluid flow through conduit 17 (for instance hot water flow or cold water flow and proper connection to the storage facilities and heating/cooling system) and the electrical modes of the thermoelectrical elements ("cogeneration", "heat pump" and "cooling") are governed by means of a controller that monitors heat- or cold demand on the basis of indoor- and storage facility temperatures and also on the basis of ambient conditions like solar radiation and temperature.

The control system can be optimized (adaptive) in a sense that e.g. production of cold water (in summertime) preferably is done during the night when ambient temperatures are relatively low and electricity relatively cheap. Likewise solar cogeneration of electricity and heat is done at high solar fluxes. In heat pump mode (for space and tap water) heating is preferably done during daytime at relatively high ambient temperatures. The storage facilities serve to allow time between supply of energy (hot and/or cold) and actual efficient production to required demand. To that end, in an embodiment the controller has a temperature sensor for measuring a temperature of fluid downstream of the energy conversion device 1. Furthermore, the controller can have a power sensor for measuring the power from (or to) the thermoelectric element. In an embodiment, the controller is operationally coupled to a fluid displacement device for displacing fluid through the second heat exchanger 16.

For a well insulated residential building a required collector area of the energy conversion device 1 typically is in the range of 50-200 m², depending on the climate and required indoor comfort level. The size of the storage facilities may lie in the range of 1 m³, also depending on climate and required indoor comfort level. Thus, the ratio of different types of heat pipes may vary depending on the desired amount of heating, cooling and electricity production.

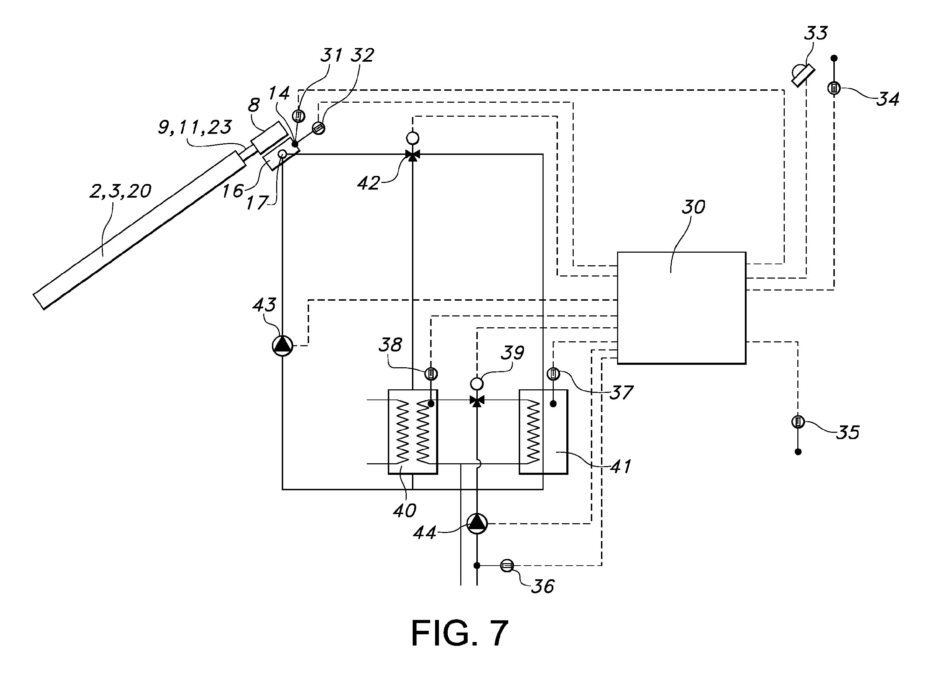

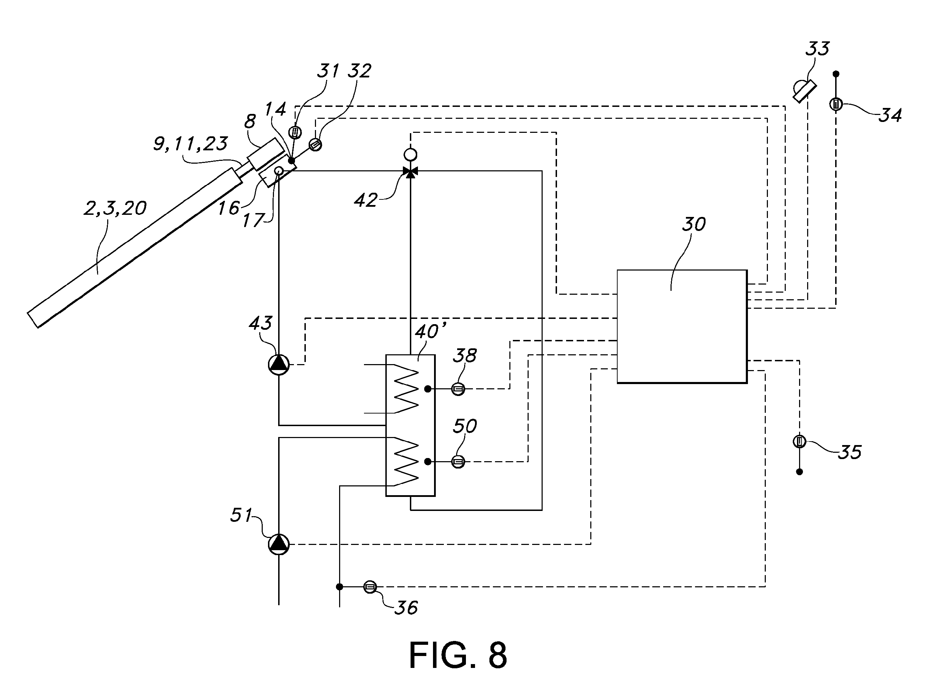

In figures 7 and 8, two examples of the energy conversion device provided with a controller and further installation components for integrating the energy conversion device in the climate conditioning system, electricity system and/or tapwater system of a building, for instance a residential building.

In figure 7, the energy conversion system comprises a controller 30. Using various sensors and controlling valves and pumps in the further installation, the energy conversion device can switch between operational modes described above. First, the controller is operationally coupled to a power sensor 31 allowing the controller 30 to determine the electrical power from or to the thermoelectric conversion element 13. Usually, the power sensor 31 is coupled to the leads 14. Furthermore, the controller is operationally coupled to a temperature sensor 32 to allow the controller to determine the temperature of heat exchanger 16 and/or of the fluid passing conduit 17. In order to collect more information to determine if the mode of operation needs to be switched, a light level sensor 33for determining the ambient light level impinging on the heat pipes is operationally coupled to controller 30. Furthermore or alternatively, a temperature sensor 34 for determining the ambient temperature of the outside world can be operationally coupled to controller 30. The input of these sensors, together with the local time, allows the controller 30 to accurately switch between modes of operation. Often, the controller also can be operationally coupled to a temperature sensor 35 that provides indoor climate conditions, in particular and at least the indoor temperature.

In order to store hot of cold fluid, the energy conversion device can be provided with a hot fluid (often water) reservoir 40 and a cold fluid (again, often water) reservoir 41. Valve 42, operationally coupled to controller 30, allows the controller to allow a fluid flow to run via the hot fluid reservoir 40 or via the cold fluid reservoir 41.

Pump 43 is operationally coupled to controller 30. Depending amongst others on hot/cold water requirements, heat exchanger/fluid temperature, the controller may control the fluid flow through pump 43. Temperature sensors 36, 37, 38 allow the controller 30 to monitor the operation of the device. Using three-way valve 39 that is operationally coupled to the controller 30, heat can be transferred between reservoirs 40 and 41. This can be actuated via pump 44 that is again operationally coupled to the controller 30.

In figure 8, the energy conversion device comprises a combined tap water/heating reservoir 40'. In this embodiment, a temperature sensors 38, 50 are operationally coupled to controller 30 to allow the controller to monitor the fluid temperature inside reservoir 40'. Pump 51, again operationally coupled to controller 30, allows heated water (or other fluid) to exchange heat with fluid from the reservoir 40' for space heating, for instance. The other heat exchanger in reservoir 40' can allow tap water to exchange heat with the fluid in the reservoir 40'.

It is to be understood that the above description is included to illustrate the operation of the preferred embodiments and is not meant to limit the scope of the invention. The scope of the invention is to be limited only by the following claims. From the above discussion, many variations will be apparent to one skilled in the art that would yet be encompassed by the spirit and scope of the present invention.

## Claims

1. An energy conversion device comprising:
- at least one vacuum tube heat pipe having a vacuum tube heat pipe condenser end and a vacuum tube heat pipe evaporator end;
- at least one ambient heat pipe having an ambient heat pipe condenser end and an ambient heat pipe evaporator end;
- at least one thermoelectric conversion element having a first end and a second end which first end and second end have a temperature difference with respect to one another when said thermoelectric conversion element is in operation,
wherein said vacuum tube heat pipe condenser end and said ambient heat pipe condenser end are thermally coupled to said first end of said thermoelectric conversion element, and wherein said at least one vacuum tube heat pipe and said at least one ambient heat pipe are configured functionally parallel.

2. The energy conversion device of claim 1, comprising at least one further ambient heat pipe having a further heat pipe condenser end and a further heat pipe evaporator end, which evaporator end is thermally coupled to said first end of said thermoelectric conversion element, and said at least one further ambient heat pipe extending functionally in a plane with said vacuum tube heat pipe and said ambient heat pipe.

3. The energy conversion device of claims 1 or 2, wherein said second end of said thermoelectric conversion element is thermally coupled to a heat exchanger having a fluid passage for exchanging heat with a fluid.

4. The energy conversion device of claim 1, 2 or 3, wherein said thermoelectric conversion element comprises one or more elements selected from the group consisting of a solid state thermoelectric conversion device, an alkali metal thermoelectric converter (AMTEC) device, a thermionic device, a Johnson thermo-electrochemical converter (JTEC) device, and a combination thereof.

5. The energy conversion device of any one of the preceding claims, wherein said thermoelectric conversion element comprises a solid state thermoelectric device.

6. The energy conversion device of any one of the preceding claims, wherein said thermoelectric conversion element comprises a Peltier device.

7. The energy conversion device according to the previous claim, wherein said further heat pipe has an inner surface, and said heat pipe comprises a wick at its inner surface allowing it to operate at an orientation with respect to the force of gravity at which the evaporator end is at a higher potential energy.

8. The energy conversion device according to any one of the preceding claims, wherein at least one of said vacuum heat pipe, ambient heat pipe, and further ambient heat pipe said comprises a valve, in particular a controllable valve.

9. The energy conversion device according to any one of the preceding claims 3-8, further comprising a controller, a temperature sensor operationally coupled to said controller and for determining a temperature of said fluid, a fluid displacement device operationally coupled to said controller and for displacing said fluid through said heat exchanger, and a power sensor operationally coupled to said at least one thermoelectric element and to said controller for determining a electrical power to or from said thermoelectric device, said controller adapted for switching between:
- a cogeneration mode in which the power sensor indicates an electrical power resulting from the at least one thermoelectric conversion element of above a set value, and said controller actuates said fluid displacement device to circulate the fluid through said heat exchanger, and
- a heat pump mode in which the power sensor indicates an electrical power below a set value and said controller receives a heating demand, and said controller provides power to said thermoelectric conversion element resulting in a heating of said first end relative to said second end.

10. The energy conversion device according to claim 9 and 2, said controller further adapted for further switching to:
- a cooling mode in which said controller receives a cooling demand, and said controller provides power to said thermoelectric conversion element in such a way that it commences cooling said first end relative to said second end.

11. A method for converting energy using the energy conversion device of claims 1 and said energy conversion device further comprising a controller, a temperature sensor operationally coupled to said controller and for determining a temperature of said fluid, a fluid displacement device operationally coupled to said controller and for displacing said fluid through said heat exchanger, and a power sensor for determining a power to or from said thermoelectric device, said method comprising the steps in which said controller:
- switches said energy conversion device to a cogeneration mode when the power sensor indicates an electrical power resulting from the at least one thermoelectric conversion element of above a set value, and said controller actuates said fluid displacement device to circulate the fluid through said heat exchanger, or
- switches said energy conversion device to a heat pump mode when the power sensor indicates an electrical power resulting from the at least one thermoelectric conversion element of below a set value and said controller receives a heating demand, and said controller provides power to said thermoelectric conversion element resulting in a heating of said first end relative to said second end.

12. A method for converting energy using the energy conversion device of claim 2 and further comprising a controller, a temperature sensor operationally coupled to said controller and for determining a temperature of said fluid, a fluid displacement device operationally coupled to said controller and for displacing said fluid through said heat exchanger, and a power sensor for determining a power to or from said thermoelectric device, said method comprising the step in which said controller:
- switches said energy device into a cooling mode when said controller receives a cooling demand, and said controller provides power to said thermoelectric conversion element in such a way that it commences cooling said first end relative to said second end.

13. A building comprising the energy conversion device according to any one of claims 1-9, wherein the energy conversion device is provided at the outside of a building at an angle of between 10-80 degrees with respect to a plumb line, in particular is the energy conversion device provided on a slanted roof of the building.
